# EUROPEAN PATENT APPLICATION

(11) **EP 2 778 827 A2**
(43) Date of publication of application: **17.09.2014**
(21) Application number: 14157716.3
(22) Date of filing: 04.03.2014
(51) Int. Cl.: G06F 1/10

(54) **Active clock tree for data converters**

(30) Priority: 15.03.2013 US 201361792062 P; 14.08.2013 US 201313967114
(71) Applicant: Analog Devices, Inc., Norwood, MA 02062-9106 (US)
(72) Inventor: Kuo, Shawn S, Norwood, MA 02476 (US); Rose, Steven C., Woburn, MA 01801 (US)
(74) Representative: Beck, Simon Antony

(57) **Abstract**

A multi-stage clock distribution circuit for an integrated circuit is provided. The clock distribution circuit may route a common clock signal to a plurality of clock receiver circuits. Each stage in the distribution circuit may include a plurality of buffers. Outputs of at least some, perhaps all, of the buffers may be connected to each other by an interconnect. The interconnect may align clock signals that are output by the interconnected buffers and thereby encourage synchronization of those clock signals. Other stages of the clock distribution signal may be connected as well.

## Description

### RELATED APPLICATION

This application claims the benefit of U.S. Provisional Patent Application No. 61/792,062 filed on March 15, 2013, which is incorporated herein by reference

### BACKGROUND OF THE INVENTION

The present invention relates to clock distribution designs, such as active clock trees. Clock distributors can be used in high speed digital to analog converters (DACs), analog to digital converters (ADCs), and clock distribution circuits which, in turn, are provided in integrated circuits.

High speed clocked circuit systems are often driven by externally supplied clock systems. Although high speed components typically operate in about the 1-20 GHz frequency range, frequencies as low as 100 MHz and higher frequencies are also used. At higher frequencies, timing mismatch requirements become stricter.

Timing mismatch is known to occur between cells in a DAC. As DACs are also used in ADCs, such as sigma-delta ADCs, the timing mismatch problem is known to occur in ADCs as well. Since each cell is spatially separated, it is difficult to provide identically timed clocks to each cell. Performance of DACs, ADCs, and other circuits, such as clock chips, can be impaired by timing mismatch errors. These errors in clock distribution can cause performance degradations such as distortions.

Accordingly, the inventors have identified a need in the art for a clock distributor system that improves clock timing match. Moreover, the inventors have identified a need in the art for a clock distribution system that can support higher speed converters.

### SUMMARY

According to a first aspect of the invention there is provided a clock distribution circuit comprising:
a plurality of buffers; and
a shorting interconnect between the buffers and a plurality of clock signal receivers.

The outputs of each of the buffers may be electrically shorted by the shorting interconnect, or outputs of a subset of the buffers may be electrically shorted by the shorting interconnect. The interconnect may be dynamically applied based on a circuit condition. The drive load of at least two of the clock receiver circuits may be different. In some variations one of the buffers drives at least two of the clock receiver circuits.

According to a second aspect of the invention there is provided a clock distribution system, comprising:
a plurality of clock receivers,
a multi-stage clock tree, having an input for a common clock signal and outputs coupled to the clock receivers, each stage comprising an array of clock buffers, wherein outputs of multiple clock buffers from a common stage are connected together.

In some embodiments outputs of all clock buffers from the common stage are connected together, whereas in other embodiments outputs of a sub-set of clock buffers from the common stage are connected together.

Advantageously outputs of multiple clock buffers from a second stage are connected together.

The clock buffers of a final stage of the clock tree may be provided in one-to-one correspondence with a corresponding clock receiver, or the clock buffers of a final stage of the clock tree may be provided in one-to-many correspondence with a corresponding clock receiver.

According to a third aspect of the present invention there is provided a clock distribution circuit comprising:
a plurality of first stage buffers;
a plurality of second stage buffers;
a first shorting interconnect between the first and second stage buffers; and
a second shorting interconnect between the second stage buffers and a plurality of clock signal receivers.

Outputs of each first stage buffer may be electrically shorted by the first shorting interconnect. In some variations outputs of a subset of first stage buffers are electrically shorted by the first shorting interconnect.

Advantageously outputs of each second stage buffer are electrically shorted by the second shorting interconnect. Alternatively, outputs of a subset of second stage buffers are electrically shorted by the second shorting interconnect.

Advantageously the first interconnect is dynamically applied based on a circuit condition.

Advantageously the second interconnect is dynamically applied based on a circuit condition.

In some embodiments the drive load of at least two of the clock signal receivers are different.

In some embodiments or variations one of the second stage buffers drives at least two of the clock receiver circuits.

According to a fourth aspect of the present invention there is provided a digital to analog converter including the clock distribution circuit according to any of the preceding aspects.

According to a fifth aspect of the present invention there is provided a method for distributing a clock signal comprising:
buffering the clock signal through a plurality of first stage buffers;
shorting the clock signal through a first shorting interconnect;
buffering the clock signal through a plurality of second stage buffers; and
shorting the clock signal through a second shorting interconnect.

Advantageously outputs of each first stage buffer are electrically shorted by the first shorting interconnect. Alternatively outputs of a subset of first stage buffer are electrically shorted by the first shorting interconnect.

Advantageously outputs of each of the second stage buffers are electrically shorted by the second shorting interconnect. Alternatively, outputs of a subset of second stage buffers are electrically shorted by the second shorting interconnect.

Advantageously the first interconnect is dynamically applied based on a circuit condition.

Advantageously the second interconnect is dynamically applied based on a circuit condition.

### BRIEF DESCRIPTION OF THE DRAWINGS

FIG. 1 illustrates an example clocking circuit that distributes a clock signal to a plurality of components according to an example embodiment of the present invention.
FIG. 2 illustrates an example single stage clocking circuit that distributes a clock signal to a plurality of components according to an example embodiment of the present invention.
FIG. 3 illustrates an example N stage clocking circuit that distributes a clock signal to a plurality of components according to an example embodiment of the present invention.
FIG. 4 illustrates an example clock distribution method according to an example embodiment of the present invention.
FIG. 5 illustrates an example clocking circuit that distributes a clock signal to a plurality of components using according to another example embodiment of the present invention.
FIG. 6 illustrates another example clocking circuit that distributes a clock signal to a plurality of components according to another example embodiment of the present invention.

### DETAILED DESCRIPTION OF THE INVENTION

The embodiments of the present invention provide a multi-stage clock distribution circuit for an integrated circuit. The clock distribution circuit may route a common clock signal to a plurality of clock receiver circuits. Each stage in the distribution circuit may include a plurality of buffers. Outputs of at least some, perhaps all, of the buffers may be connected to each other by an interconnect. The interconnect may align clock signals that are output by the interconnected buffers and thereby encourage synchronization of those clock signals. Other stages of the clock distribution signal may be connected as well.

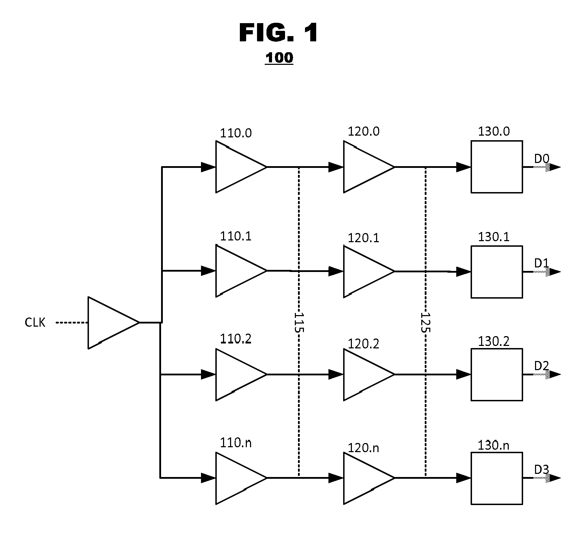

FIG. 1 illustrates an example clock tree 100 according to an embodiment of the present invention. The tree 100 may be a multi-stage clock distribution system that propagates a common input clock CLK to a plurality of clock receivers 130.0-130.n. An example two stage tree 100 is illustrated in FIG. 1, which may include a plurality of first stage buffers 110.0-110.n and a plurality of second stage buffers 120.0-120.n. An interconnect 115 may extend among outputs of the first stage buffers 110.0-110.n. Alternatively, or in addition, an interconnect 125 may extend between outputs of second stage buffers 120.0-120.n.

The input clock signal can be connected directly to the first stage buffers 110.0-110.n, which distribute the clock signal to the second stage buffers 120.0-120.n. After each buffer stage, clock buffer outputs can be shorted by first and second interconnects 115, 125 to same stage clock buffer outputs. In advance of a subsequent stage, the first interconnect 115 shorts the output of first stage buffers 110.0-110.n. Similarly, the second interconnect 125 shorts the output of second stage buffers in advance of clock signal receivers 130.0-130.n.

Because interconnect 115 shorts buffers 110.0-110.n, clock signals output by buffers 110.0-110.n pull together and align. Similarly, since interconnect 125 shorts buffers 120.0-120.n, clock signals output by buffers 120.0-120.n pull together and align. Accordingly, clock averaging is provided, timing mismatch errors are attenuated, and clock jitter is reduced. After one or more stages, the clock signal aligns. In addition, the power of a clock driver (not shown) and the overall system can be reduced.

In addition, the drive load of each clock signal receiver 130.0-130.n (or other load circuit) may vary, and buffers and corresponding clock recivers may be tuned to each other. For example, buffer sizes can be adapted to match corresponding loads (i.e., clock receiver loads).

The example clock trees can be applied to a variety of clock or signal distribution systems, especially when it is desirable to maintain synchronization between spatially separated portions of a circuit. In some instances, one or more portions of a clock tree can be incorporated into the circuit cells of individual components. For example, one or more portions of a clock tree can be incorporated into a DAC cell. In this example, a clock tree may be implemented by a plurality of DAC cells. A DAC cell is a circuit block that can generate a weighted current/voltage. Cells generally consist of a latch and a current/voltage generating element that will create the analog output. Many cells can be arranged to form a multi-bit DAC/ADC. In a DAC cell, the current/voltage is updated at every clock edge based on the data input into the cell. Here, accurate timing of current/voltage output will achieve low distortion signal generation. Thus, lower distortion can be achieved by attenuating timing error using the clock trees of the present invention. By using a clock tree, the timing across multiple cells will be averaged such that each cell will have identical output timing.

A clock signal may be a system clock signal, or other clock signal provided by a clock generator (not shown), that is provided as a reference to synchronize the various electronic components, such as clock receivers 130.0-130.n. In various implementations, the clock receivers 130.0-130.n may be provided as latches, logic gates, flip-flops, or other circuit that operate in a common clock domain. Other components may employ the example clocking scheme such as, for example, various components of a processor, bus, or memory (e.g., RAM, cache, etc.). In another example, the clocking scheme can be applied to a low-skew data bus that will drive a DAC output.

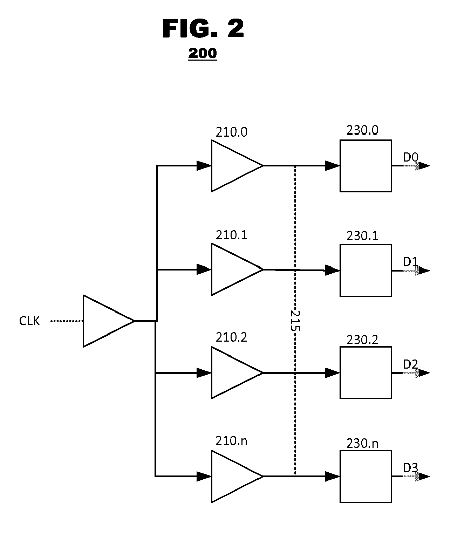

FIG. 2 illustrates an example clock tree 200 according to an embodiment of the present invention. The tree 200 may be a single-stage clock distribution system that propagates a common input clock CLK to a plurality of clock receivers 230.1-230.n. An example single stage tree 200 is illustrated in FIG. 2, which may include a plurality of buffers 210.0-210.n and a plurality clock signal receivers 230.0-230.n. An interconnect 215 may extend among outputs of the buffers 210.0-210.n.

In the example one-stage configuration shown in FIG. 2, the clocking tree 200 includes clock buffers 210.0-210.n that drive clock signal receivers 230.0-230.n. The input clock signal can be connected directly to the buffers 210.0-210.n, which distribute the clock signal to the clock signal receivers 230.0-230.n. After buffers 210.0-210.n, clock buffer outputs can be shorted by interconnect 215.

In advance of clock signal receivers 230.0-230.n, interconnect 215 shorts the output of buffers 210.0-210.n. Because interconnect 215 provides an electrical short, the clock signals pull together and align. Accordingly, clock averaging is provided, timing mismatch errors are attenuated, and clock jitter is reduced. Compared to the two-stage example, the one-stage clock tree provides a coarser degree of alignment and error attenuation. In the one-stage example, the power of a clock driver (not shown) and the overall system can also be reduced.

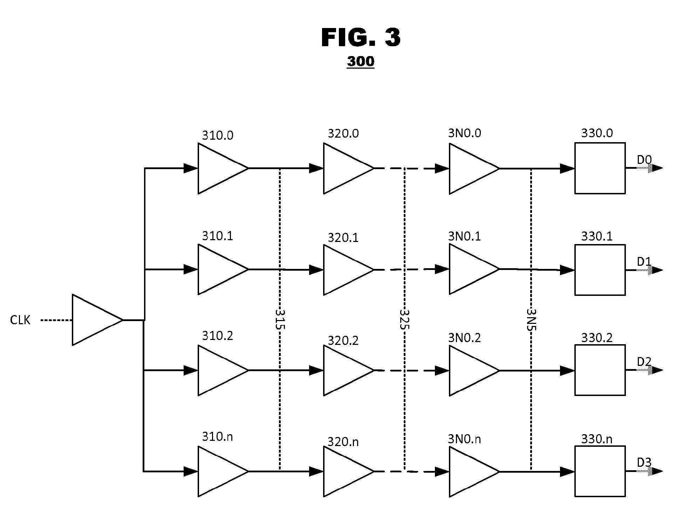

Although one and two-stage configurations have been described, the present invention accommodates various numbers (N) of stages as may be desired. FIG. 3 illustrates an example clock tree 300 according to an embodiment of the present invention. The tree 300 may be a N-stage clock distribution system that propagates a common input clock CLK to a plurality of clock receivers 330.0-330.n. The example N-stage clock tree 300 includes a plurality of first stage buffers 310.0-310.n, a plurality of second stage buffers 320.0-320.n, and so on, until a plurality of Nth stage buffers 3N0.0-3N0.n. An interconnect 315 may extend among outputs of the first stage buffers 310.0-310.n. Alternatively, or in addition, an interconnect 325 may extend between outputs of second stage buffers 320.0-320.n. Similarly, an interconnect 3N5 may extend between outputs of successive stage buffers 3N0.0-3N0.n within the tree 300.

In the example N-stage configuration shown in FIG. 3, the clocking tree 300 includes clock buffers 310.0-310.n that drive clock signal receivers 330.0-330.n. The input clock signal can be connected directly to the first stage buffers 310.0-310.n, which distribute the clock signal to the second stage buffers 320.0-320.n, and so on. After each buffer stage, clock buffer outputs can be shorted by interconnects 315, 325, and so on to same stage clock buffer outputs.

In an N stage configuration, N stages of clock buffers can be used to drive the back-end clock signal receivers 330.0-330.n. Each of the N stage clock buffer outputs may be shorted to the same stage clock buffer outputs. Similar to the one and two stage configurations, clock averaging is used to reduce timing mismatch errors. Accordingly, clock averaging is provided, timing mismatch errors are attenuated, and clock jitter is reduced. As the number of stages increases, a higher degree of alignment and error attenuation can be achieved.

In instances with larger error, additional stages of clock buffers can be used. The resistance, magnetic coupling, or capacitive coupling of the shorting interconnects can vary the number of stages used in a clock tree. For example, when the resistance of interconnects is low, less stages are needed. Low resistance also improves clock phase noise outputted by the clock buffers resulting in an improved signal to noise ratio.

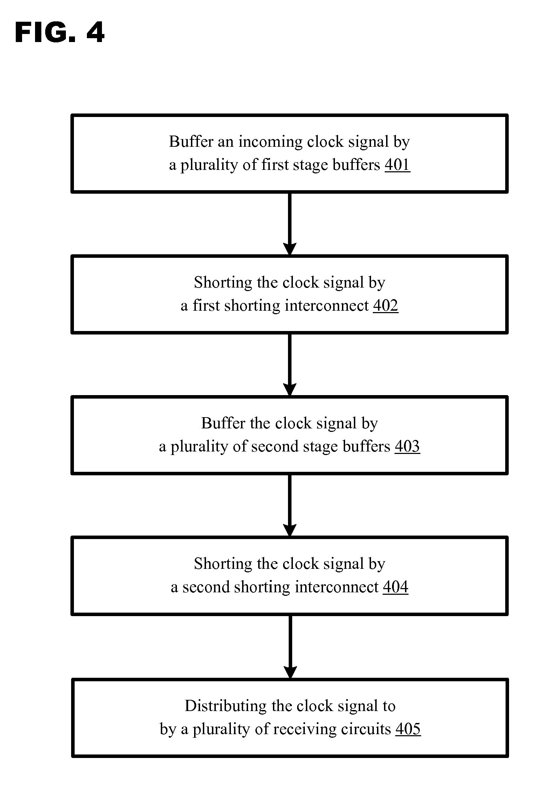

FIG. 4 illustrates an example clock distribution method for distributing a clock signal. At 401, a plurality of first stage buffers, such as 110.0-110.n, buffer an incoming clock signal. Next, at 402, the clock signal is shorted by a first shorting interconnect, such as interconnect 115. At 403, the clock signal is relayed through a plurality of second stage buffers, such as 120.0-120.n. Next, at 404, the clock signal is shorted by a second shorting interconnect, such as interconnect 125. Lastly, at 405, the clock signal is relayed to clock receiving circuits, such as 130.0-130.n.

Although interconnects discussed above, such as interconnects 115 and 125, have been depicted as shorting each of buffers 110.0-110.n and 120.0-120.n respectively, interconnects can also be adapted to connect one or more subsets of the buffers in their respective stages.

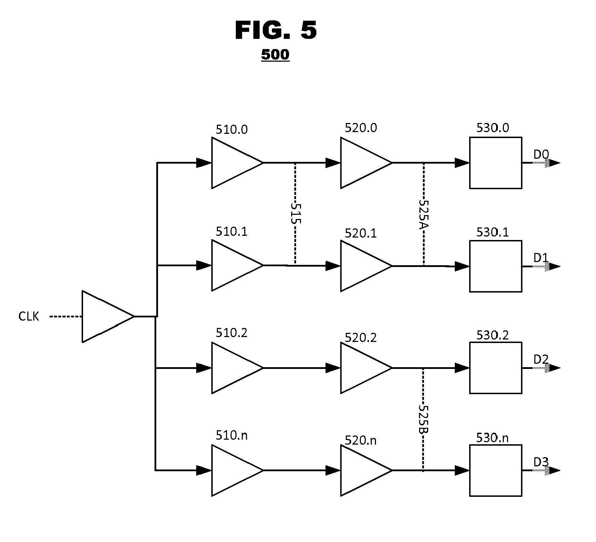

FIG. 5 illustrates an example clock tree 500 according to another embodiment of the present invention. The tree 500 may be a multi-stage clock distribution system that propagates a common input clock CLK to a plurality of clock receivers 530.0-530.n. An example two stage tree 500 is illustrated in FIG. 5, which may include a plurality of first stage buffers 510.0-510.n and a plurality of second stage buffers 520.0-520.n. A partial interconnect 515 may extend among outputs of one or more subsets of the first stage buffers 510.0-510.n. Alternatively, or in addition, a partial interconnect 525 may extend between outputs of one or subsets of second stage buffers 520.0-520.n.

In an example clock tree 500 shown in FIG. 5, partial interconnect 515 may short only buffers 510.0 and 510.1. Similarly, interconnect 525A may short only buffers 520.0 and 520.1 and interconnect 525B may short only buffers 520.2 and 520.n. In another example, interconnects can be applied dynamically based on expected circuit conditions, such as estimated circuit parasitics and/or propagation delay.

In the example embodiments discussed above, such as clocking tree 100, each buffer can be used to drive a corresponding clock signal receiver. For example, clock buffers 110.2 and 120.2 drive clock receiver 130.2. However, a buffer can also be adapted to drive multiple receiving circuits.

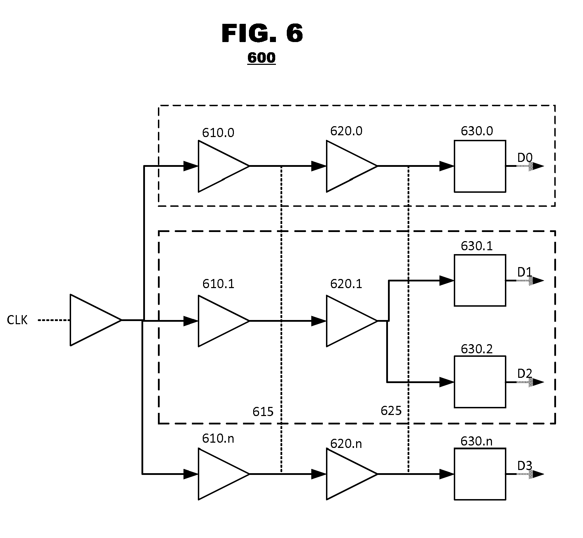

FIG. 6 illustrates an example clock tree 600 according to another embodiment of the present invention. The tree 600 may be a multi-stage clock distribution system that propagates a common input clock CLK to a plurality of clock receivers 630.0-630.n. An example two stage tree 600 is illustrated in FIG. 6, which may include a plurality of first stage buffers 610.0-610.n and a plurality of second stage buffers 620.0-620.n. An interconnect 615 may extend among outputs of the first stage buffers 610.0-610.n. Alternatively, or in addition, an interconnect 625 may extend between outputs of second stage buffers 620.0-620.n. In the example clock tree 600, a buffer can be adapted to drive one or more corresponding clock receivers. For example, clock buffers 610.1 and 620.1 can be adapted to drive clock signal receivers 630.1 and 630.2, whereas clock buffers 610.0 and 620.0 drive clock receiver 630.0. Of course, numerous other configurations are possible. In particular, a multi-stage clock tree having M buffers (or stages) may be adapted to drive N clock receivers, for all integers M and N. For example, three buffers may be applied to drive five clock receivers.

Using embodiments described herein, clocks with higher frequencies can be utilized. As compared to prior architectures, the clock distribution system of the present invention reduces time skew while also reducing power consumption in the clock and maintaining low noise. For example, using the clocking scheme, less than 50fs of clock skew over 32 bits across 1mm of wide clock tree at 5 GHz could be achieved. Including the flip-flop, bit skew of under 200fs was achieved.

It will be apparent to those skilled in the art that various modifications and variations can be made in the clock distribution system of the present invention without departing from the spirit or scope of the invention. Thus, it is intended that the present invention cover the modifications and variations of this invention provided they come within the scope of the appended claims and their equivalents.

## Claims

1. A clock distribution circuit comprising:
a plurality of buffers (110, 120); and
a shorting interconnect (125) between the buffers and a plurality of clock signal receivers.

2. A clock distribution circuit as claimed in claim 1, where the buffers are arranged as a plurality of first stage buffers (110) and a plurality of second stage buffers (120) and a first shorting interconnect (115) is provided between the first and second stage buffers; and a second shorting interconnect (125) is provided between the second stage buffers and a plurality of clock signal receivers.

3. A clock distribution system as claimed in claim 1, comprising:
a plurality of clock receivers (130.0 to 130.n),
a multi-stage clock tree, having an input for a common clock signal and outputs coupled to the clock receivers, each stage comprising an array of the buffers, wherein outputs of multiple clock buffers from a common stage are connected together.

4. The clock distribution system of claim 2 or 3, wherein outputs of all clock buffers from the common stage are connected together.

5. The clock distribution system of claim 2, 3 or 4 wherein outputs of a sub-set of clock buffers from the common stage are connected together.

6. The clock distribution circuit according to claim 2, 3, 4, or 5, wherein outputs of each first stage buffer are electrically shorted by the first shorting interconnect, or wherein outputs of a subset of first stage buffers are electrically shorted by the first shorting interconnect.

7. The clock distribution circuit according to claim 2, 3, 4, 5 or 6 wherein outputs of each second stage buffer are electrically shorted by the second shorting interconnect, or wherein outputs of a subset of second stage buffers are electrically shorted by the second shorting interconnect.

8. The clock distribution circuit according to claim 2 or any claim dependent on claim 2 where at least one of the following applies:
a) the first interconnect is dynamically applied based on a circuit condition;
b) the second interconnect is dynamically applied based on a circuit condition.

9. The clock distribution circuit according to claim 1, wherein outputs of each of the buffers are electrically shorted by the shorting interconnect, or wherein outputs of a subset of the buffers are electrically shorted by the shorting interconnect.

10. The clock distribution circuit according to claim 1 where at least one of the following applies:
a) the interconnect is dynamically applied based on a circuit condition;
b) the drive load of at least two of the clock receiver circuits are different;
c) one of the buffers drives at least two of the clock receiver circuits.

11. A digital to analog converter including the clock distribution circuit according to any preceding claim.

12. The clock distribution system of claims 1 to 9, wherein clock buffers of a final stage of the clock tree are provided in one-to-one correspondence with a corresponding clock receiver, or wherein clock buffers of a final stage of the clock tree are provided in one-to-many correspondence with a corresponding clock receiver.

13. A method for distributing a clock signal comprising:
buffering the clock signal through a plurality of first stage buffers;
shorting the clock signal through a first shorting interconnect;
buffering the clock signal through a plurality of second stage buffers; and
shorting the clock signal through a second shorting interconnect.

14. The method for distributing a clock signal as claimed in claim 13, in which at least one of the following applies:
a) wherein outputs of each first stage buffer are electrically shorted by the first shorting interconnect; or wherein outputs of a subset of first stage buffer are electrically shorted by the first shorting interconnect;
b) or wherein outputs of each of the second stage buffers are electrically shorted by the second shorting interconnect; or wherein outputs of a subset of second stage buffers are electrically shorted by the second shorting interconnect;
c) wherein the first interconnect is dynamically applied based on a circuit condition;
d) wherein the second interconnect is dynamically applied based on a circuit condition.

15. The method for distributing a clock signal as claimed in claim 14, wherein the drive load of at least two clock receivers coupled to the second stage buffers are different, or wherein one of the second stage buffers drives at least two of the clock receiver circuits.
